Europäisches Patentamt

**European Patent Office**

Office européen des brevets

(19)

(11) Publication number : **0 366 930 B1**

## (12) EUROPEAN PATENT SPECIFICATION

(45) Date of publication of patent specification :
07.12.94 Bulletin 94/49

(51) Int. Cl.⁵ : **H01L 29/812, H01L 29/10**

(21) Application number : **89117868.3**

(22) Date of filing : **27.09.89**

(54) **Semiconductor device including a MESFET.**

(30) Priority : **30.09.88 JP 246632/88**
**30.09.88 JP 246633/88**
**30.09.88 JP 246634/88**
**30.09.88 JP 246635/88**

(43) Date of publication of application :
**09.05.90 Bulletin 90/19**

(45) Publication of the grant of the patent :
**07.12.94 Bulletin 94/49**

(84) Designated Contracting States :
**DE FR GB IT NL SE**

(56) References cited :
**EP-A- 0 317 345**
**INTERNATIONAL ELECTRON DEVICE MEET-**
**ING, Los Angeles, 7th-10th December**
**1986,pages 829-831, New York, US; U.K. MIS-**
**HRA et al.: "MBE Grown GaAs MESFETs with**
**ultra-high gm and fT"**
**APPLIED PHYSICS LETTERS, vol. 48, no. 23,**
**9th June 1986, pages 1620-1622; J.H.ABELES**
**et al.: "Nonlinear high-frequency response of**
**GaAs metal-semiconductor field-effect tran-**
**sistors"**

(56) References cited :
**ELECTRONICS LETTERS, vol. 21, no. 15, July**
**1985, pages 636-638; R.E. NEIDERT et al.:**
**"Voltage variable microwave phase shifter"**
**I.E.E.E. ELECTRON DEVICE LETTERS, vol.**
**EDL-8, no. 3, March 1987, pages 113-115;P.**
**CANFIELD et al.: "Buried-channel GaAs MES-**
**FET's with immunity to ionizing optical radi-**
**ation effects"**

(73) Proprietor : **SUMITOMO ELECTRIC**
**INDUSTRIES, LTD.**
**5-33, Kitahama 4-chome,**
**Chuo-ku**
**Osaka-shi, Osaka 541 (JP)**

(72) Inventor : **Nishiguchi, Masanori Yokohama**
**Works of Sumitomo**
**Electric Industries, Ltd.**
**1, Taya-cho**
**Sakae-ku**
**Yokohama-shi Kanagawa (JP)**
Inventor : **Okazaki, Naoto**
**Nissin Electric Co. Ltd.**
**47, Umezu Takaune-cho**
**Ukyo-ku Kyoto (JP)**

(74) Representative : **Kahler, Kurt, Dipl.-Ing.**
**Patentanwälte Kahler, Käck, Fiener & Sturm**
**P.O. Box 12 49**
**D-87712 Mindelheim (DE)**

## Description

(Background of the Invention)

This invention relates to a semiconductor device using a GaAs metal-semiconductor field effect transistor (MESFET), specifically to that which can be used in machines and instruments requiring radiation hardness or radiation resistance.

(Related Background Art)

The devices which are used in aerospace systems and near nuclear reactors require a high radiation hardness. The radiation includes gamma ($\gamma$) rays, neutron rays, proton rays, etc. Generally the gallium arsenide (GaAs) MESFETs and ICs based upon these FETs will withstand total exposure dose of $1\times10^8$ roentgens with little if any change in characteristics. By contrast, silicon (Si) MOS circuits have failed at dose of $1\times10^6$ roentgens (Proceedings of Symposium of Space Development, 1987, ps. 35 $\sim$ 38).

For improving the radiation hardness of the GaAs MESFET, the following art have been proposed. In a first one, a p-type layer is buried below an n-type active layer to thereby decrease leakage current to the substrate, and the threshold voltage of a GaAs FET is improving in the radiation hardness. In a second one, the Schottky gate of a GaAs FET is shortened.

But these prior art have improved the radiation hardness up to a total exposure dose R of about $1 \times 10^8$ roentgens, but it cannot be said that these prior art have succeeded in attaining the sufficiently practical level ($1 \times 10^9$ roentgens). Under these circumstances, no practical transistor having a radiation hardness level of about $1 \times 10^9$ roentgens has been realized.

On the other hand, Physics of Semiconductor Device, 2nd Edition, S.M. Sze., P. 334, describes a MESFET having two active layers. This MESFET has realized superior characteristics since the carrier concentration in the surface of the active layer decreases and consequently the MESFET is free from the affection of a deletion layer.

International Electron Device Meeting, 7th-10th December 1986, pages 829-831 discloses a GaAs MESFET comprising a highly doped thin active channel layer, a thin barrier channel with reduced doping level and an AlGaAs buffer layer, wherein the highly doped active layer confines the depletion depths both laterally and vertically into the channel. This decreases the effective electrical length of the device which minimizes the parasitic gate capacitance and increases the device transconductance through enhanced charge control of the channel by the gate electrode. There is no teaching about a MESFET-structure providing a radiation hardness.

Therefore, an object of this invention is to provide a GaAs MESFET which has a simple structure and a high radiation hardness which has been improved by especially making use of changes of at least one of the threshold voltage, the saturated drain current, and the transconductance.

## Summary of the Invention

The inventors have noticed that when radiation is applied to a GaAs MESFET, the change amount $\Delta V_{th}$ of the threshold voltage $V_{th}$ in the saturation region, the change rate $\alpha = I_{dssA}/I_{dss}$ of saturated drain current at normal gate bias $I_{dss}$, and the change rate $\beta = g_{mA}/g_m$ of a transconductance $g_m$ has a constant relationship with the effective thickness $t_a = t_{a1} + t_{a2}$ of the active layer and the change amount $\Delta N_D$ of the carrier concentrations $N_{1D}$, $N_{2D}$ and has found that the change amount $\Delta N_D$ has a constant quantitative relationship with the total exposure dose R. Based on this finding, they have completed this invention as defined in claim 1.

In this arrangement, under irradiation of a total exposure dose even above $1\times10^9$ roentgens, at least any one of the threshold voltage $V_{th}$, the saturated drain current $I_{dss}$, and the transconductance $g_m$ are within their corresponding preset ranges (tolerable ranges determined by the signal processing circuit). Consequently, the semiconductor device according to this invention comprising the GaAs MESFET and a signal processing circuit can operate normally as initially designed.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter.

BRIEF DESCRIPTION OF THE DRAWINGS

Fig. 1 is a sectional view of a GaAs MESFET explaining the principle of this invention;

Fig. 2 is a graph showing the total exposure dose R dependence of a change amount $\Delta V_{th}$ of the threshold voltage of the MESFET involved in this invention;

Fig. 3 is a graph showing the total exposure dose R dependence of a decrease amount $\Delta N_D$ of the carrier concentration;

Fig. 4 is a graph showing the result of the experiment on the total exposure dose R dependence of a change amount $\Delta V_{th}$ of the threshold voltage of a conventional MESFET;

Fig. 5 is a graph showing the total exposure dose R dependence of a change rate $\alpha$ of the saturated drain current of the MESFET involved in this invention;

Fig. 6 is a graph showing the total exposure dose R dependence of a change of the saturated drain current $I_{dss}$;

Fig. 7 is a graph showing the total exposure dose R dependence of a change rate $\beta$ of the transconductance of the MESFET involved in this invention;

Fig. 8 is a graph showing the results of the experiments on the total exposure dose R dependence of a change of the transconductance $g_m$ of the conventional MESFET;

Figs. 9 to 11 are characteristic curves of the threshold voltage, saturated drain current, and transconductance of the MESFET involved in this invention and of the conventional FETs for comparison in radiation hardness; and

Fig. 12 is a sectional view of a GaAs MESFET having an active layer in one layer.

DESCRIPTION OF THE PREFERRED EMBODIMENT

This invention will be explained in good detail with reference to the drawings showing the principle and structure of this invention.

The semiconductor device according to this invention comprises a GaAs MESFET, and a signal processing circuit cooperatively combined with the MESFET. The MESFET and the signal processing circuit can provide combination circuits, e.g., amplifiers, inverters, oscillaters, digital logic arrays, etc. The MESFET in this combination circuit involved in this invention has a preset threshold voltage $V_{th}$, a saturated drain current $I_{dss}$ at normal gate bias, and a transconductance $g_m$ in the saturation region. It has been known that their values change under radiation exposure. When a changed threshold voltage $V_{thA}$, a changed saturated drain current $I_{dssA}$, and a changed transconductance $g_{mA}$ of which the initial values have changed due to radiation exposure are out of their preset ranges by the signal processing circuit, this combination circuit does not normally operate. Hereinafter in this specification, a tolerable value of a change amount $\Delta V_{th}$ of the threshold voltage $V_{th}$ is represented by a tolerable change amount $\Delta V_{thL}$. A tolerable value of a change rate $\alpha = I_{dssA}/I_{dss}$ of the saturated drain current $I_{dss}$ is represented by a tolerable change rate $\alpha_L$, and a tolerable value of a change rate $\alpha = g_{mA}/g_m$ of the transconductance is represented by a tolerable change rate $\beta_L$. The values of $\Delta V_{thL}$, $\alpha_L$ and $\beta_L$ vary depending on designs of the above described signal processing circuit, but generally $\Delta V_{thL}$ equal to or is lower than 0.2 V, and $\alpha_L$ and $\beta_L$ equal to or are higher than 0.8.

As described above, it is known that the threshold voltage $V_{th}$, etc. change under radiation exposure. As causes for these changes have been reported, firstly, decreases in a carrier concentration of the active layer due to radiation exposure, and secondly decreases in an electron mobility therein due to radiation exposure. The inventors discussed the first cause in good detail and found the relationship

$$\Delta N_D = b \cdot R^c \quad (1)$$

where b and c are constants holds between a decrease amount $\Delta N_D$ of a carrier concentrations $N_{1D}$, $N_{2D}$ and a total exposure dose R. Formula 1 holds when an initial carrier concentration $N_{2D}$ (before radiation exposure) of the active layer is $1 \times 10^{17} \sim 1 \times 10^{19} cm^{-3}$, a total dose R of exposure radiation is $1 \times 10^8 \sim 1 \times 10^{10}$ roentgens. The constants b and c have some ranges depending on changes of an initial carrier concentration of the active layer, qualities of the substrates, etc. According to the experiments conducted by the inventors, the constants b and c have ranges of

$$1.99 \times 10^{10} \leqq b \leqq 3.98 \times 10^{10}$$
$$0.5 \leqq c \leqq 0.8$$

and the typical values are $b = 3.06 \times 10^{10}$, $c = 0.678$. Therefore, the typical value of the decrease amount $\Delta N_D$ of the carrier concentration is defined by

$$\Delta N_D = 3.06 \times 10^{10} \cdot R^{0.678}.$$

The experiment in which the relationship of Formula 1 was found will be explained below in good detail.

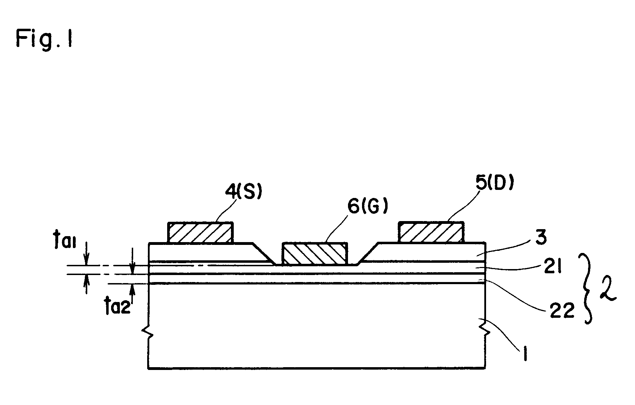

Fig. 1 shows a sectional view of a selectively grown n$^+$ source/drain GaAs MESFET having a recessed

3

gate. As shown in Fig. 1, an n-type active layer 2, and an $n^+$ doped contact region 3 are formed on a semi-insulating GaAs substrate 1. The active layer 2 includes an upper layer 21 of a thickness $t_{a1}$ and a lower layer 22 of a thickness $t_{a2}$. Parts of the n-type active layer 2 and the $n^+$ doped contact region 3 for a gate region to be provided are etched off to form a recess structure. Then a source electrode 4 and a drain electrode 5 of ohmic metal are formed on the $n^+$ doped contact region 3 by the vacuum evaporation. A gate electrode 6 of Schottky-barrier metal is formed on the n-type active layer 2. The part of the n-type active layer 2 directly below the gate electrode 6 has a sufficiently smaller thickness, an effective thickness of about 450 Å, compared with the n-type active layers of the conventional MESFETs (each having a thickness of about 1000 Å (10Å = 1nm)). The lower layer 22 has a thickness of $t_{a2} = 150$ Å, the upper layer 21 has a thickness of $t_{a1} = 300$ Å. The active layer 2 has a higher carrier concentration $N_{2D}$ in the lower part thereof compared with the carrier concentrations of the conventional MESFETs, specifically the lower layer 22 has a carrier concentration of $N_{2D} = 3 \times 10^{18} cm^{-3}$, the upper layer 21 has a carrier concentration of $N_{1D} = 2 \times 10^{17} cm^{-3}$.

The theoretical value of the threshold voltage $V_{th}$ of this GaAs MESFET is given by

$$V_{th} = V_{bi} - (q \cdot N_{2D}/2\varepsilon)t_{a2}{}^2 - (q \cdot N_{2D}/\varepsilon)t_{a1} \cdot t_{a2} - (q \cdot N_{1D}/2\varepsilon)t_{a1}{}^2 \quad (2)$$

given by solving the one dimensional Poisson equation

$$d^2\phi_1/d\chi^2 = - qN_{1D}/\varepsilon$$
$$(0 \leqq \chi \leqq t_{a1})$$
$$d^2\phi_2/d\chi^2 = - qN_{2D}/\varepsilon$$
$$(t_{a1} \leqq \chi \leqq t_{a1} + t_{a2})$$

under the boundary conditions of

$$d\phi/d\chi = 0 \text{ at } \chi = t_{a1} + d \ (d > t_{a2})$$
$$\phi = - (V_{bi} - V_G) \text{ at } \chi = 0.$$

In Formula 2, $V_{bi}$ represents a built-in voltage of the MESFET; q, an electron charge; and $\varepsilon$, a dielectric constant of the n-type active layer 2. When the carrier concentrations $N_{1D}$, $N_{2D}$ of the n-type active layer 2 becomes $N_{1DA}$, $N_{2DA}$ due to radiation exposure, a threshold voltage $V_{thA}$ after the radiation exposure is given by

$$V_{thA} = V_{bi} - (q \cdot N_{2DA}/2\varepsilon)t_{a2}{}^2 - (q \cdot N_{2DA}/\varepsilon)t_{a1} \cdot t_{a2} - (q \cdot N_{1DA}/2\varepsilon)t_{a1}{}^2 \quad (3).$$

Then, a change amount of the threshold voltage $V_{th}$ due to the radiation exposure is given by

$$
\begin{aligned}
\Delta V_{th} &= V_{thA} - V_{th} \\
&= \{V_{bi} - (q \cdot N_{2DA}/2\varepsilon)t_{a2}{}^2 \\
&\quad - (q \cdot N_{2DA}/\varepsilon)t_{a1} \cdot t_{a2} \\
&\quad - (q \cdot N_{1DA}/2\varepsilon)t_{a1}{}^2\} \\
&\quad - \{V_{bi} - (q \cdot N_{2D}/2\varepsilon)t_{a2}{}^2 \\
&\quad - (q \cdot N_{2D}/\varepsilon)t_{a1} \cdot t_{a2} \\
&\quad - (q \cdot N_{1D}/2\varepsilon)t_{a1}{}^2\} \\
&= \{[q \cdot (t_{a1} + t_{a2})^2)]/2\varepsilon\} \cdot (N_D - N_{DA}) \qquad \ldots \ldots (4).
\end{aligned}
$$

In Formula 4

$$
\begin{aligned}
N_D - N_{DA} &= N_{1D} - N_{1DA} \\
&= N_{2D} - N_{2DA}.
\end{aligned}
$$

Therefore when a decrease amount of the carrier concentration due to radiation exposure is given by

$$\Delta N_D = N_D - N_{DA},$$

with $t_a = t_{a1} + t_{a2}$,

$$\Delta V_{th} = \{(q \cdot t_a{}^2)/2\varepsilon\} \cdot \Delta N_D \quad (5).$$

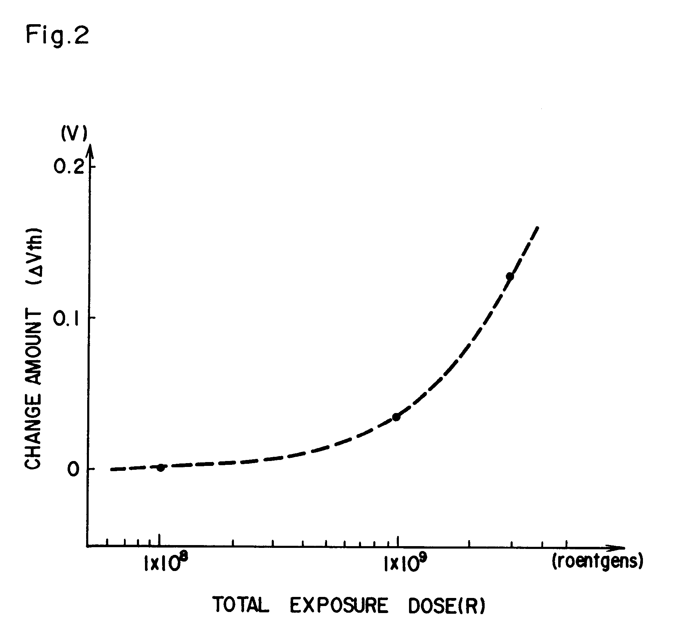

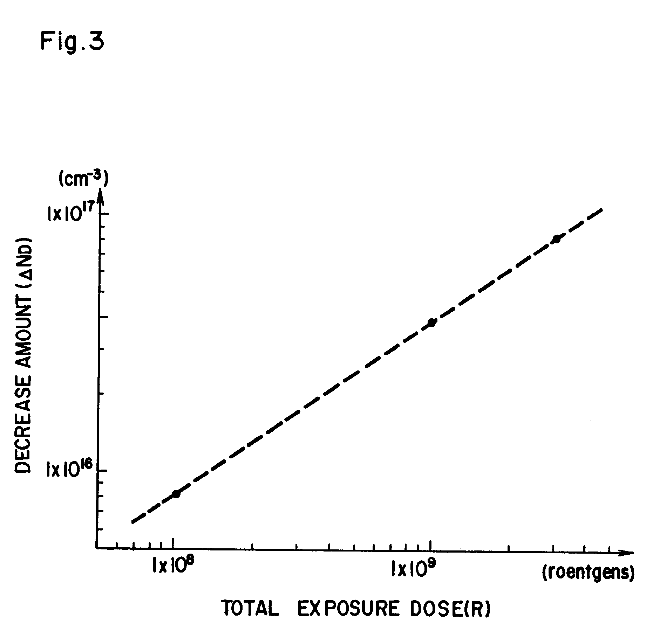

The inventors further studied the change amount $\Delta V_{th}$ of the threshold voltage $V_{th}$ by irradiating gamma rays in total exposure doses $R=1\times10^8$ roentgens, $1\times10^9$ roentgens and $3\times10^9$ roentgens to a MESFET of Fig. 1 having the active layer 2 of a thickness of 450 Å (=150+300). The result is shown in Fig. 2 by black points. Based on the results in Fig. 2, using Formula 5, change amounts (decrease amounts) $\Delta N_D$ of the carrier concentration are indicated by the black points for total doses of $R=1\times10^8$ roentgens, $1\times10^9$ roentgens, and $3\times10^9$ roentgens in Fig. 3, which shows that the above described formula

$$\Delta N_D = 3.06 \times 10^{10} \cdot R^{\,0.678} \quad (1)$$

(the dot line of Fig. 3) holds. When Formula 1 is applied to Fig.2, the dot line in Fig. 2 is obtained. This shows that the experimental result and the theoretical values well agree. In Fig. 2, with a total dose of $R=1\times10^9$ roentgens, a change amount $\Delta V_{th}$ of the threshold voltage is as low as about 0.04V. Therefore, it is confirmed that the radiation hardness is conspicuously improved when the active layer 2 has a thickness of about 450 Å.

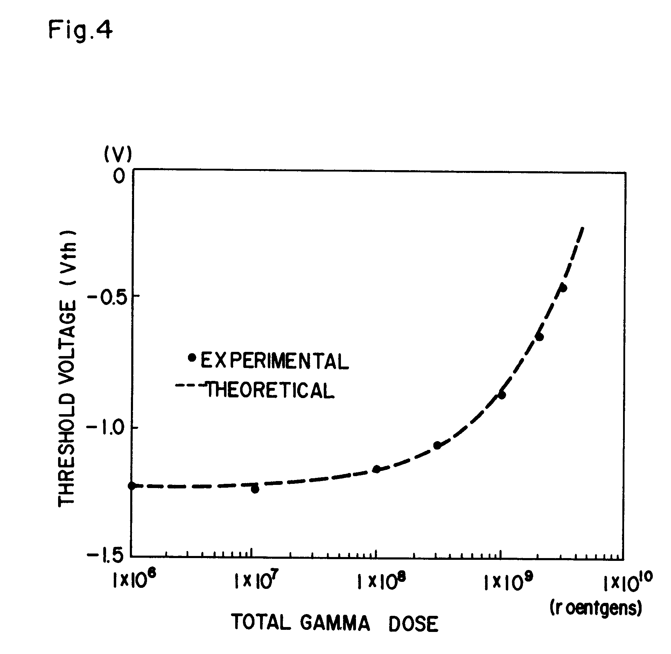

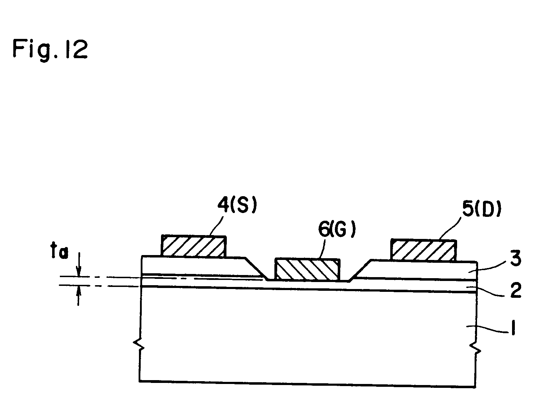

Formula 1 described above was derived from actually measured values for three total doses of $R=1\times10^8$ roentgens, $1\times10^9$ roentgens and $3\times10^9$ roentgens. It can be said that these values are insufficient data to derive a general formula. Then the inventors conducted a further experiment of irradiating gamma rays from cobalt 60 to the GaAs MESFET of Fig. 12 which had the same geometrical structure except that in the active layer as the GaAs MESFET involved in this invention and has the active layer 2 in one layer. The active layer 2 had an effective thickness $t_a$ of 1130 Å so that the carrier concentration $N_D$ is $2.09\times10^{17}\text{cm}^{-3}$. In this experiment, total exposure doses were $R=1\times10^6$ roentgens, $1\times10^7$ roentgens, $1\times10^8$ roentgens, $3\times10^8$ roentgens, $1\times10^9$ roentgens, $2\times10^9$ roentgens and $3\times10^9$ roentgens. The resultant change amounts $\Delta V_{th}$ of the threshold voltage are shown in Fig. 4 by the black points. These points well agree with the theoretical values indicated by the dot line. The change amounts $\Delta V_{th}$ after a radiation exposure of $R=1\times10^9$ roentgens, however, was about 0.4V, which was remarkably inferior to that in Fig.2.

The results of these experiments on the threshold voltage show the following. Firstly, a major cause for the degradation of the threshold voltage of the MESFET due to radiation damage is a decrease in the carrier concentration of the active layer, and it was found that Formula 1 well expresses a decrease in the carrier concentration under the radiation exposure. Secondly, it has found that the change amount $\Delta V_{th}$ of the threshold voltage $V_{th}$ can be set at a required value by setting only the thickness $t_a=t_{a1}+t_{a2}$ of the active layer. Specifically, as shown in Fig. 4, when the thickness $t_a$ of the active layer 2 is set at about 1000 Å as in the conventional MESFETs, the radiation hardness is insufficient, but as shown in Fig. 2, when the thickness $t_a=t_{a1}+t_{a2}$ is set at 450 Å, the radiation hardness is conspicuously improved.

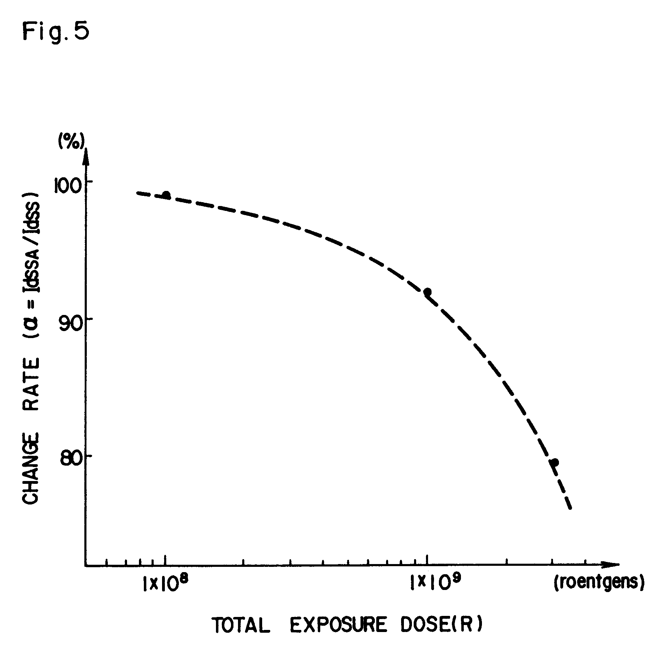

Then, the inventors actually measured changes of the saturated drain current $I_{dss}$ due to the radiation exposure of the same GaAs MESFETs as those which exhibited the threshold voltages $V_{th}$ of Figs. 2 and 4. As a result, the characteristic of the change rate $\alpha$ of the saturated drain current $I_{dss}$ of Fig. 5 was obtained in use of same MESFET of Fig. 2.

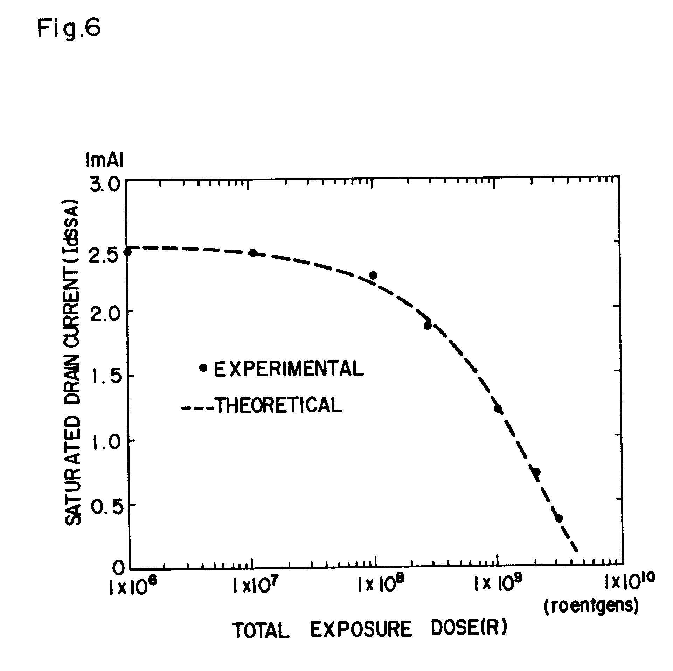

The saturated drain current $I_{dss}$ of Fig. 6 was obtained in use of same MESFET of Fig. 4. In Figs. 5 and 6, the black points indicate the experimental values, and the dot lines indicate the theoretical values given by applying Formula 10 described below to Formula 1.

The theoretical formula for the change rate $\alpha=I_{dssA}/I_{dss}$ of the saturated drain current $I_{dss}$ will be derived below. The saturated drain current $I_{dss}$ of the MESFET is given for an intrinsic FET with a source resistance $R_s$ kept out of consideration, by

$$
\begin{aligned}
I_{dss} = & \{(W_g\cdot\mu\cdot q^2\cdot N_{2D}{}^2)/(\varepsilon\cdot L_g)\} \\
& \times \{t_{a1}\cdot t_{a2}(t_{a2} + t_{a1} - d_1) \\
& + (t_{a2} - t_{a1})\cdot[t_{a2}{}^2 - (-t_{a1} + d_1)^2]/2 \\
& - [t_{a2}{}^3 - (-t_{a1} + d_1)^3]/3\} \\
\text{where } d_1 = & \{t_{a1}{}^2 - N_{1D}\cdot t_{a1}{}^2/N_{2D} + 2\varepsilon \\
& \cdot (V_{bi} - V_G)/(q\cdot N_{2D})\}^{1/2} \quad (6).
\end{aligned}
$$

In Formula 6, $W_g$ represents a gate width; $\mu$, an electron mobility in the active layer 2; $L_g$, a gate length; and $V_G$, a gate voltage. In Formula 6, $N_{1D}/N_{2D}=0$ based on $N_{1D}<N_{2D}$. Therefore, Formula 6 is rewritten $d_1=t_{a1}$. When a saturated drain current $I_{dss}$ for $V_G=V_{bi}$ is represented by $I_{DSS}$ for simplifying the computation, Formula 6 is rewritten into

$$I_{DSS} = \{(W_g\cdot\mu\cdot q^2\cdot N_{2D})/(\varepsilon\cdot L_g)\}\cdot[t_{a1}\cdot t_{a2}{}^2 + (t_{a2} - t_{a1})t_{a2}{}^2/2 - t_{a2}{}^3/3] \quad (7)$$

when a saturated drain current after the radiation exposure is represented by $I_{DSSA}$, a change rate $\alpha$ due to the radiation exposure is given based on Formula 7 by

$$
\begin{aligned}
\alpha &= I_{DSSA}\,/\,I_{DSS} \\
&= (\mu_A\cdot N_{2DA}{}^2)\,/\,(\mu\cdot N_{2D}{}^2) \quad \ldots\ldots(8)
\end{aligned}
$$

where $N_{2DA}$ is a carrier concentration of the lower layer after the radiation exposure and is given by

$$N_{2DA} = N_{2D} - \Delta N_D \quad (9).$$

Then Formula 8 is substituted by Formula 9 into

$$\alpha = \{\mu_A (N_{2D} - \Delta N_D)^2\}/(\mu \cdot N_{2D}^2) \quad (10).$$

Then Formula 10 will be discussed below. It is found that the change rate $\alpha$ is influenced by changes ($\mu \rightarrow \mu_A$) of the electron mobility $\mu$ due to the radiation exposure. But $\mu_A/\mu$ is around 0.95 - 0.98 when the carrier concentration before the radiation exposure is about $1 \times 10^{18} cm^{-3}$. The change becomes smaller as the carrier concentration becomes higher. Then the computation was made with $\mu_A/\mu = 0.95$. The results were the dot lines of Figs. 5 and 6. As described above, it was confirmed that the results agreed with the experimental values.

These experiments on the saturated drain current $I_{dss}$ and the studies of their results show the following. Firstly, a major cause for the degradation of the $I_{dss}$ of the MESFET as total dose radiation effects is a decrease of the carrier concentration of the active layer, and it was found that Formula 1 is very explanatory of the decrease of the carrier concentration due to the radiation exposure. Secondly, the change rate $\alpha$ of the saturated drain current can be set at a required value by setting only the initial carrier concentration (before the radiation exposure) $N_{2D}$ of the lower layer 22 of the active layer, because $\mu$ is a constant in Formula 10, the value of $\mu_A/\mu$ can be approximated, and $\Delta N_D$ can be determined depending on a total radiation dose in Formula 1. Specifically, when the carrier concentration $N_D$ of the active layer 2 is set at about $2 \times 10^{17} cm^{-3}$ as in the conventional ones, the radiation hardness is insufficient as seen in Fig. 6. When the carrier concentration $N_{2D}$ of the lower layer is set at $1 \times 10^{18} cm^{-3}$, the radiation hardness is outstandingly improved as seen in Fig. 5.

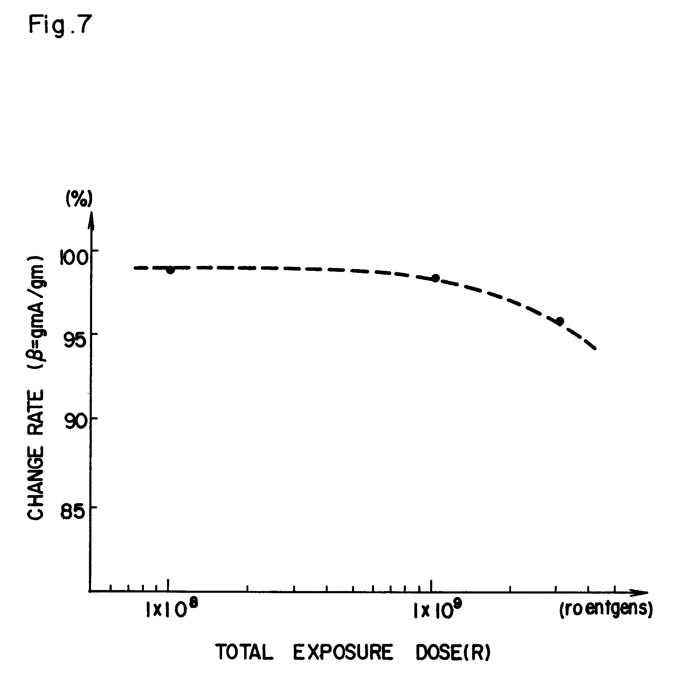

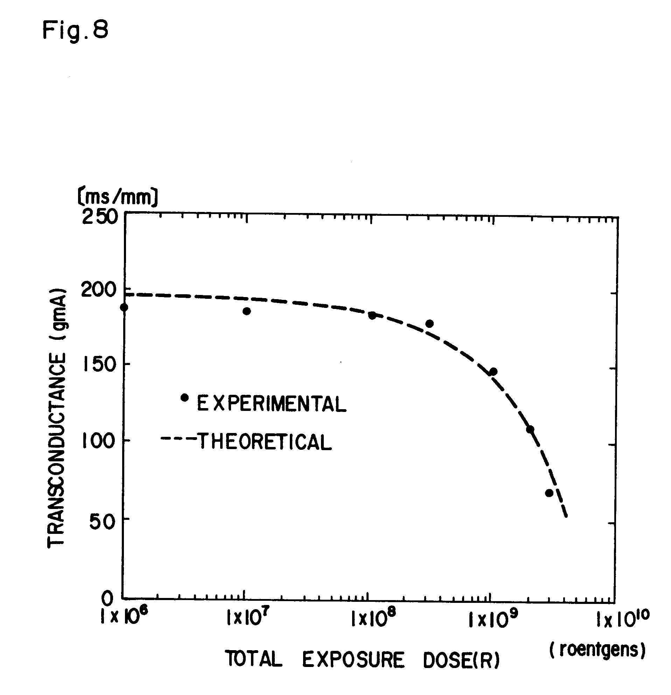

Then, the inventors actually measured changes of the transconductances $g_m$ due to the radiation exposure in the saturation regions of the same GaAs MESFETs as those which exhibited the threshold voltages $V_{th}$ of Figs. 2 and 4 and the saturated drain current $I_{dss}$ characteristics of Figs. 5 and 6. As results, the change rate $\beta$ of the transconductance $g_m$ of Fig. 7 was obtained in use of same MESFET of Fig. 2 and 5, and the transconductance $g_m$ of Fig. 8 was obtained in use of same MESFET of Fig. 4 and 6. In Figs. 7 and 8, the black points indicate the experimental values, and the dot lines indicate the theoretical values given by applying Formula 15 described below to Formula 1.

The theoretical formula for the change rate $\beta = g_{mA}/g_m$ of the transconductance will be derived below. A transconductance $g_m$ in the saturation region of the MESFET is given for an intrinsic FET with a source resistance $R_s$ kept out of consideration, by

$$g_m = \{(W_g \cdot \mu \cdot q \cdot N_{2D})/(d_1 \cdot L_g)\} \times \{- t_{a1} \cdot t_{a2}(t_{a2} + t_{a1}) + (t_{a2} - t_{a1}) \cdot [t_{a2}^2 - 2(d_1 - t_{a1})^2]/2 + [t_{a2}^3 - (d_1 - t_{a1})^3]/3\}$$

In this Formula,

$$d_1 = \{t_{a1}^2 - N_{1D} \cdot t_{a1}^2/N_{2D} + 2\varepsilon \cdot (V_{bi} - V_G)/(q \cdot N_{2D})\}^{1/2} \quad (11).$$

In Formula 11, $N_{1D}/N_{2D} = 0$ based on $N_{1D} < N_{2D}$. Therefore, Formula 11 is rewritten $d_1 = t_{a1}$. When a transconductance $g_m$ for $V_G = V_{bi}$ is represented by $g_{mmax}$ for simplifying the computation, Formula 11 is rewritten into

$$g_{mmax} = \{(W_g \cdot \mu \cdot q \cdot N_{2D})/(t_{a1} \cdot L_g)\} \cdot [- t_{a1} \cdot t_{a2}^2(t_{a1} + t_{a2}) - (t_{a2} - t_{a1}) t_{a2}^2/2 + t_{a2}^3/3] \quad (12).$$

A change rate $\beta$ due to the radiation exposure is given based on Formula 12 by

$$\beta = g_{mmaxA} / g_{mmax}$$
$$= (\mu_A \cdot N_{2DA}) / (\mu \cdot N_{2D}) \qquad \ldots\ldots(13)$$

where $N_{2DA}$ is a carrier concentration of the lower layer after the radiation exposure and given by

$$N_{2DA} = N_{2D} - \Delta N_D \quad (14).$$

Then Formula 13 is substituted by Formula 14 into

$$\beta = \{\mu_A(N_{2D} - \Delta N_D)\}/(\mu \cdot N_{2D}) \quad (15).$$

Then Formula 15 will be discussed below. It is found that the change rate $\beta$ is influenced by changes ($\mu \rightarrow \mu_A$) of the electron mobility $\mu$ due to the radiation exposure. But $\mu_A / \mu$ is around 0.95 when the carrier concentration before the radiation exposure is about $1 \times 10^{18} cm^{-3}$. The change becomes smaller as the carrier concentration becomes higher. Then the computation was made with $\mu_A/\mu = 0.95$. The results were the dot lines of Figs. 7 and 8. As described above, it was confirmed that the results agreed with the experimental values.

These experiments and the studies of their results show the following. Firstly, a major cause for the degradation of the transconductance of the MESFET as total dose radiation effect is a decrease of the carrier concentration in the active layer, and it was found that Formula 1 is very explanatory of the decrease of the carrier concentration due to the radiation exposure. Secondly, the change rate $\beta$ of the transconductance can be set at a required value by setting only the initial carrier concentration $N_{2D}$ of the lower layer 22 of the active layer,

because $\mu$ is a constant in Formula 15, the value of $\mu_A/\mu$ can be approximated, and $\Delta N_D$ is determined based on Formula 1, depending on a radiation dose. Specifically, when the carrier concentration $N_D$ of the active layer 2 is set at about $2\times10^{17}cm^{-3}$ as in the conventional ones, the radiation hardness is insufficient as seen in Fig. 8. When the carrier concentration $N_{2D}$ in the lower layer is set at $1\times10^{18}cm^{-3}$, the radiation hardness is outstandingly improved as seen in Fig. 7.

It is possible that, based on the above described findings, a structure of a semiconductor device which is able to operate normally under the radiation exposure of a total dose R not only below $1\times10^9$ roentgens but also a total dose R above $1\times10^9$ roentgens can be specified based on a thickness $t_a$ of the active layer 2 and a carrier concentration $N_{2D}$ in the lower layer 22. That is, in order that a GaAs MESFET and a signal processing circuit are combined into such semiconductor device, and the signal processing circuit can operate as designed when a tolerable change amount of the threshold voltage $V_{th}$ of the MESFET is $\Delta V_{thL}$, an effective thickness $t_a=t_{a1}+t_{a2}$ of the active layer 2 must be

$$t_a < \{(2\varepsilon\cdot\Delta V_{thL})/(q\cdot\Delta N_D)\}^{1/2} \quad (16),$$

based on Formula 5. In this case, the carrier concentration $N_{2D}$ of the lower layer 22 of the active layer 2 is given as follows based on Formula 2 by

$$N_{2D} = \{[2\varepsilon/(q\cdot t_a^2)]\cdot(V_{bi} - V_{th})\} \quad (17)$$

Here, when a tolerable change amount $\Delta V_{thL}$ of the threshold voltage $V_{th}$ for a total exposure dose of $R=1\times10^9$ roentgens is specifically computed by

$$\Delta V_{thL} = 0.1V(\Delta V_{th} < 0.1V),$$

a change amount $\Delta N_D$ of the carrier concentration is given by

$$\Delta N_D = 3.87 \times 10^{16}cm^{-3}.$$

An effective thickness $t_a=t_{a1}+t_{a2}$ of the active layer 2 is given below 585 Å (450 Å for the MESFET of Fig. 2), based on Formula 16. Further, with a thickness of the active layer 2 set at below 585 Å, the carrier concentrations $N_{1D}$, $N_{2D}$ of the active layer is determined by their interrelationships with the thickness $t_{a1}$, $t_{a2}$. In this case, a dielectric constant of the active layer

$$\varepsilon = \varepsilon_s\cdot\varepsilon_0$$
$$= 12.0 \times 8.85 \times 10^{-12}F/m$$

an electron charge

$$q = 1.602 \times 10^{-19}C,$$

and

a built-in voltage $V_{bi} = 0.7V$.

In order that the combination circuit relates to the semiconductor device operates as required when a tolerable change rate of the saturated drain current $I_{dss}$ of the MESFET is represented by $\alpha_L$, an initial carrier concentration $N_{2D}$ of the lower layer 22 of the active layer 2 must be, based on Formula 10 by

$$N_{2D} > \Delta N_D /\{1 - [\alpha_L(\mu/\mu_A)]^{1/2}\} \quad (18).$$

In this case, an effective thickness $t_a=t_{a1}+t_{a2}$ of the active layer 2 is given by

$$t_a = \{[2\varepsilon/(q\cdot N_{2D})](V_{bi} - V_{th})\} \quad (19).$$

Here, for a total exposure dose of $R=1\times10^9$ roentgens, with $\alpha_L$ (a tolerable change rate of the saturated drain current $I_{DSS}$)=0.9 ($I_{DSSA}>0.9I_{DSS}$), a change amount $\Delta N_D$ of the carrier concentration is given based on Formula 1 by

$$\Delta N_D = 3.87 \times 10^{16}cm^{-3},$$

and the carrier concentration $N_{2D}$ of the lower layer 22 of the active layer 2 becomes above $1.45\times10^{18}cm^{-3}$ based on Formula 10.

Further, in order that the GaAs MESFET and a signal processing circuit are combined into this semiconductor device, and the signal processing circuit can operate as designed when a tolerable change rate of the transconductance $g_m$ in the saturation region of the MESFET is $\beta_L$, an initial carrier concentration $N_{2D}$ of the lower layer 22 of the active layer 2 must be, based on Formula 15,

$$N_{2D} > \Delta N_D /\{1 - \beta_L (\mu/\mu_A)\} \quad (21).$$

In this case, an effective thickness $t_a=t_{a1}+t_{a2}$ of the active layer 2 must be

$$t_a = \{[\varepsilon/(q\cdot N_{2D})]\}(V_{bi} - V_{th})\}^{1/2} \quad (22).$$

Here, for a total exposure dose of $R=1\times10^9$ roentgens, with $\beta_L$ (a tolerable change rate of the transconductance $g_{mmax}$) = 0.9 ($g_{mmaxA} >0.9 g_{mmax}$), a change amount $\Delta N_D$ is given by

$$\Delta N_D = 3.87 \times 10^{16}cm^{-3}$$

based on Formula 1. The carrier concentration $N_{2D}$ of the lower layer of the active layer 2 is given above

$7.35 \times 10^{17} cm^{-3}$ by Formula 15.

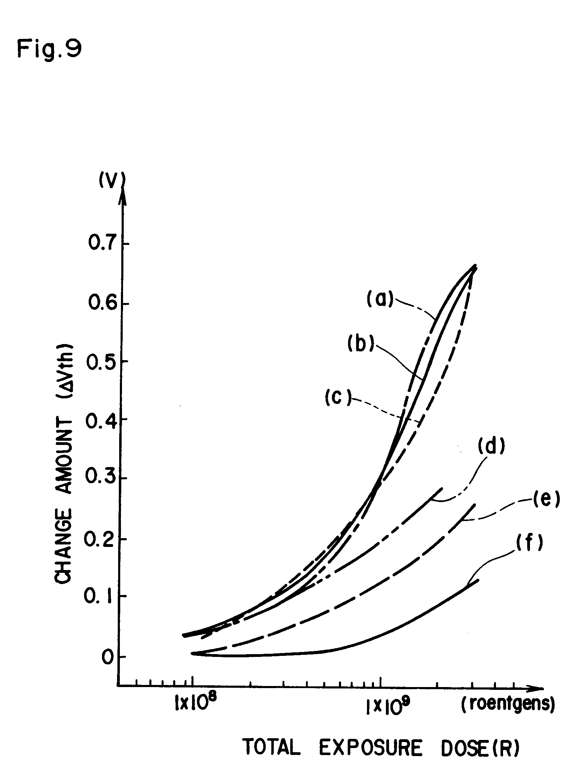

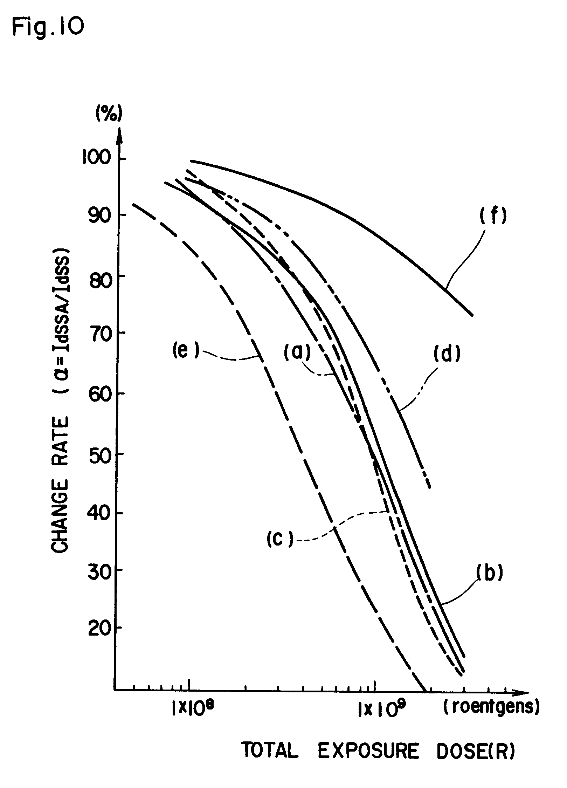

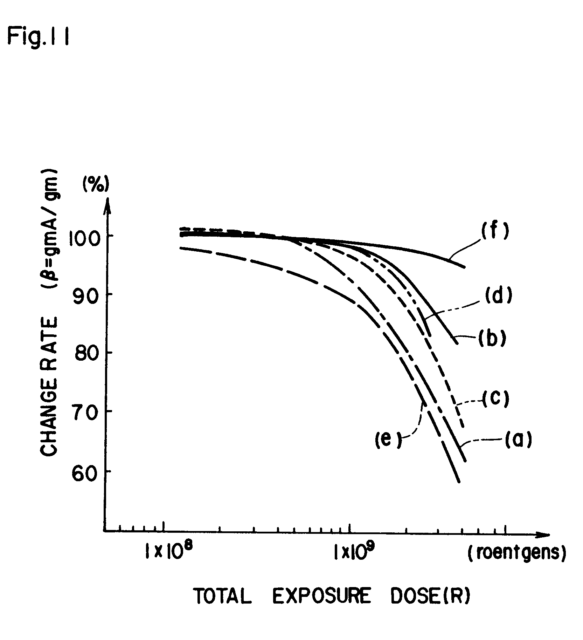

The semiconductor device according to this invention and the conventional ones will be compared in radiation hardness in Figs. 9 to 11. Fig. 9 shows change amounts $\Delta V_{th}$ of the threshold voltage $V_{th}$ due to the radiation exposure. Fig. 10 shows change rates $\alpha$ of the saturated drain current $I_{dss}$. Fig. 11 shows change rates $\beta$ of the transconductance $g_m$. In Figs. 9 - 11, curves (a), (b) and (c) show characteristics of the conventional commercial MESFETs. The curve (b) corresponds to the characteristics of Figs. 4, 6 and 8 for the active layer 2 of a 1130 Å effective thickness $t_a$ and a carrier concentration of $2.09 \times 10^{17} cm^{-3}$. The curve (d) shows the characteristics of a conventional HEMT (high electron mobility transistor). As evident from Fig. 9, these conventional semiconductor devices have change amounts $\Delta V_{th}$ of the threshold voltage as high as 0.2 to 0.3V for a total dose of $R=1 \times 10^9$ roentgens. The curve (e) in Fig. 9 shows the characteristic of a MESFET having a p-type layer buried below an n-type active layer for decreasing leakage current to the substrate, and the change amount $\Delta V_{th}$ is suppressed to about 0.12V for $R=1 \times 10^9$ roentgens. In contrast to this, in the MESFET according to this invention having the active layer 2 of an effective thickness $t_a=t_{a1}+t_{a2}$ of 450 Å (corresponding to the characteristic of Fig. 2), the change amount $\Delta V_{th}$ is suppressed to a value lower than 0.1V even for $R=1 \times 10^9$ roentgens as indicated by the curve (f), and it is found that the radiation hardness is much improved. It is evident from Figs. 10 and 11 that such improvement in the radiation hardness is also exhibited in the saturated drain current $I_{dss}$ and the transconductance $g_m$.

In this invention, even under the radiation exposure of a total exposure dose equal to or higher than $R=1 \times 10^8$ roentgens, the values of the threshold voltage $V_{th}$, saturated drain current $I_{dss}$ and transconductance $g_m$ remain within their tolerable ranges. A GaAs MESFET which is acknowledged as superior in radiation hardness characteristic must have radiation hardness to a total exposure dose of about $1.4 \times 10^8 \sim 4.3 \times 10^9$ roentgens. For this exposure dose, the absorbed dose of GaAs is totally $1 \times 10^8 \sim 3 \times 10^9$ rad.(1 roentgens = 0.7 rads. in GaAs). On the other hand, the tolerable range of the change (positive shift) amount $\Delta V_{th}$ of the threshold voltage $V_{th}$ is 0.2 V, and the tolerable ranges of the change rates $\alpha=I_{dss}/I_{dss}$, $\beta=g_{mA}/g_m$ of the saturated drain current $I_{dss}$ and the transconductance $g_m$ are about 80%. Specifically, when the change amount $\Delta V_{th} = 0.15V$ with a total exposure dose $R=1.5 \times 10^9$ roentgens, it can be said that the GaAs MESFET has superior radiation hardness.

But what has to be noted here is that the above described tolerable change amount $\Delta V_{thL}$, and the tolerable change rates $\alpha_L$, $\beta_L$ greatly vary depending on circuits combined with the GaAs MESFET. Specifically, one example is SCFL (Source coupled FET Logic) circuits which have low integrity but have enabled high speed operation. In theses circuits, the operation speed is substantially determined by a current flowing two transistors in the buffer stages. Accordingly, when values of the $V_{th}$, $I_{dss}$ and $g_m$ vary due to a radiation exposure, the operation speed greatly varies. But the influence on the operation speed by the changes of values of $V_{th}$, $I_{dss}$ and $g_m$ can be reduced by $1/3 \sim 1/4$ by setting the values of resistors of the SCFL circuit at suitable values. Consequently, even in a SCFL circuit which allows for a change of the operation speed of only 10%, the tolerable change is 200 m/V for the threshold voltage $V_{th}$ ($V_{thL}=0.2V$), and the tolerable changes for the saturated drain current $I_{dss}$ and the transconductance $g_m$ are about 20% ($\alpha_L=0.8$, $\beta_L=0.8$).

By contrast, another example is a memory cell for a memory IC which have high integrity on a semiconductor chip, the tolerable range for those changes are narrowed. Specifically, in this IC, a time in which one small memory cell charges and discharges the data lines occupies a large part of a total access time. Furthermore, each memory cell has the transistors, resistors, etc. miniaturized for reducing power consumption. Consequently, the operation speed greatly varies depending on changes of the parameters. Specifically, in order to keep the change of the memory access time within 20%, the tolerable change amount of the threshold voltage $V_{th}$ is only 50 mV ($\Delta V_{thL} = 0.05V$), and the tolerable change rates of the saturated drain current $I_{dss}$ and the transconductance $g_m$ are only 10% ($\alpha_L=0.9$, $\beta_L=0.9$).

This invention is not limited to the above described embodiment and covers various modifications.

For example, the active layer is not necessarily formed by the epitaxial growth but may be formed by the ion implantation. The recess structure of Fig. 1 is not essential.

## Claims

1. A radiation resistive semiconductor device comprising a signal processing circuit combined with a MESFET having a semi-insulating GaAs substrate (1) with an active layer (2) said active layer comprising an upper layer (21) having a carrier concentration $N_{1D}$ and an effective thickness $t_{a1}$, and a lower layer (22) having a carrier concentration $N_{2D}$ and an effective thickness $t_{a2}$, wherein $N_{1D} < N_{2D}$, said active layer being directly formed on said substrate (1), and a gate electrode (6) formed on said active layer (2), said MESFET having a threshold voltage $V_{th}$ with a change amount $\Delta V_{th}$, a saturated drain current $I_{dss}$ with a change rate $\alpha$ and a transconductance $g_m$ with a change rate $\beta$, these parameters being changed upon exposure of the device to a radiation exposure of a total dose R equal to or higher than $1 \times 10^9$ roentgens within admissible change amounts $\Delta V_{thL}$ and $\alpha_L$ and $\beta_L$, respectively, wherein $\Delta V_{thL} \leqq 0.2$ V, $\alpha_L$ and $\beta_L \geqq 0.8$, the effective thickness $t_a = t_{a1} + t_{a2}$ of the active layer (2) being given by

$$t_a < \{(2\varepsilon \cdot \Delta V_{thL}) / (q \cdot \Delta N_D)\}^{1/2}$$

and

the carrier concentration $N_{2D}$ of the lower layer (22) before the radiation exposure being given by

$$N_{2D} > \Delta N_D / \{1 - [\alpha_L (\mu/\mu_A)]^{1/2}\}$$

and/or

$$N_{2D} > \Delta N_D / \{1 - \beta_L (\mu/\mu_A)\},$$

where $\mu$ and $\mu_A$ represent the carrier mobilities in the active layer (2) respectively before and after the radiation exposure, $\Delta N_D$ the decrease of carrier concentrations $N_{1D}$ or $N_{2D}$ of the upper and lower layers (21,22) due to the radiation exposure, $\varepsilon$ the dielectric constant of the active layer (2), and q the electron charge.

2. A semiconductor device according to claim 1, wherein a decrease amount $\Delta N_D$ of the carrier concentration is given by

$$\Delta N_D = b \cdot R^c$$

where b and c are constants.

3. A semiconductor device according to claim 2, wherein the constants b and c are

$$1.99 \times 10^{10} \leqq b \leqq 3.98 \times 10^{10}$$
$$0.5 \leqq c \leqq 0.8.$$

## Patentansprüche

1. Eine strahlungsbeständige Halbleitervorrichtung mit einer Signalverarbeitungsschaltung, die mit einem MESFET kombiniert ist, der ein halbisolierendes GaAs-Substrat (1) mit einer aktiven Schicht (2) und eine auf der aktiven Schicht (2) ausgebildete Gateelektrode (6) aufweist, wobei die aktive Schicht eine obere Schicht (21) mit einer Ladungsträgerkonzentration $N_{1D}$ und einer wirksamen Dicke $t_{a1}$ und eine untere Schicht (22) mit einer Ladungsträgerkonzentration $N_{2D}$ und einer wirksamen Dicke $t_{a2}$ aufweist, wobei $N_{1D} < N_{2D}$ ist und die aktive Schicht (2) direkt auf dem Substrat (1) ausgebildet ist, wobei der MESFET eine Schwellenspannung $V_{th}$ mit einem Änderungsbetrag $\Delta V_{th}$, einen gesättigten Drainstrom $I_{dss}$ mit einer Änderungsrate $\alpha$ und eine Vorwärtssteilheit $g_m$ mit einer Änderungsrate $\beta$ aufweist, wobei diese Parameter, nachdem die Vorrichtung einer Strahlenbelastung mit einer Gesamtdosis R von $1 \times 10^9$ Röntgen oder mehr ausgesetzt wurde, innerhalb zulässiger Änderungsbeträge $\Delta V_{thL}$ bzw. $\alpha_L$ bzw. $\beta_L$ geändert sind, wobei $\Delta V_{thL} \leqq 0{,}2$V, $\alpha_L$ und $\beta_L \geqq 0{,}8$ sind,
die wirksame Dicke $t_a = t_{a1} + t_{a2}$ der aktiven Schicht (2) durch

$$t_a < \{(2\varepsilon \cdot \Delta V_{thL}) / (q \cdot \Delta N_D)\}^{1/2}$$

und

die Ladungsträgerkonzentration $N_{2D}$ der unteren Schicht (22) vor der Strahlenbelastung durch

$$N_{2D} > \Delta N_D / \{1 - [\alpha_L (\mu/\mu_A)]^{1/2}\}$$

und/oder

$$N_{2D} > \Delta N_D / \{1 - \beta_L (\mu/\mu_A)\}$$

gegeben ist, wobei $\mu$ und $\mu_A$ die Ladungsträgerbeweglichkeiten in der aktiven Schicht (2) entsprechend vor und nach der Strahlenbelastung, $\Delta N_D$ die Abnahme der Ladungsträgerkonzentrationen $N_{1D}$ oder $N_{2D}$ der oberen und der unteren Schicht (21, 22) aufgrund der Strahlenbelastung, $\varepsilon$ die dielektrische Konstante der aktiven Schicht (2) und q die Elektronenladung darstellen.

2. Eine Halbleitervorrichtung nach Anspruch 1, wobei ein Abnahmebetrag $\Delta N_D$ der Ladungsträgerkonzentration durch

$$\Delta N_D = b \cdot R^c$$

bestimmt ist, wobei b und c Konstanten sind.

3. Eine Halbleitervorrichtung nach Anspruch 2, wobei für die Konstanten b und c

$$1{,}99 \times 10^{10} \leqq b \leqq 3{,}98 \times 10^{10} \text{ bzw.}$$
$$0{,}5 \leqq c \leqq 0{,}8$$

gilt.

**Revendications**

1. Un dispositif semi-conducteur résistant aux radiations comprenant un circuit de traitement du signal combiné avec un transistor à effet de champ métal-semiconducteur comportant un substrat GaAs semi-isolant (1) avec une couche active (2), ladite couche active comprenant une couche supérieure (21) comportant une concentration de porteurs $N_{1D}$ et une épaisseur efficace $t_{a1}$, et une couche inférieure (22) comportant une concentration de porteurs $N_{2D}$ et une épaisseur efficace $t_{a2}$, dans lequel $N_{1D} < N_{2D}$, ladite couche active étant directement formée sur ledit substrat (1) et une électrode de grille (6) formée sur ladite couche active (2), ledit transistor à effet de champ métal-semiconducteur comportant une tension de seuil $V_{th}$ avec une quantité de variation $\Delta V_{th}$, un courant de drain saturé $I_{dss}$ avec un taux de variation $\alpha$ et une transconductance $g_m$ avec un taux de variation $\beta$, ces paramètres étant changés par l'exposition du dispositif à une dose d'exposition aux radiations totale R égale ou supérieure à $1 \times 10^9$ roentgens à l'intérieur de quantités de variation pouvant être admises $\Delta V_{thL}$ et $\alpha_L$ et $\beta_L$, respectivement, dans lequel
   $\Delta V_{thL} \leqq 0,2$ volts, $\alpha_L$ et $\beta_L \geqq 0,8$,
   l'épaisseur efficace $t_a = t_{a1} + t_{a2}$ de la couche active (2) étant donnée par
   $$t_a < \{(2\varepsilon \cdot \Delta V_{thL}) / (q \cdot \Delta N_D)\}^{1/2}$$
   et
   la concentration de porteurs $N_{2D}$ de la couche inférieure (22) avant l'exposition aux radiations étant donnée par
   $$N_{2D} > \Delta N_D / \{1 - [\alpha_L (\mu/\mu_A)]^{1/2}\}$$
   et/ou
   $$N_{2D} > \Delta N_D / \{1 - \beta_L (\mu/\mu_A)\},$$
   où $\mu$ et $\mu_A$ représentent les mobilités de porteurs dans la couche active (2) respectivement avant et après l'exposition aux radiations, $\Delta N_D$ la diminution des concentrations de porteurs $N_{1D}$ ou $N_{2D}$ des couches supérieures et inférieures (21, 22) du fait de l'exposition aux radiations, $\varepsilon$ la constante diélectrique de la couche active (2) et q la charge d'électron.

2. Dispositif à semi-conducteur conformément à la revendication 1, dans lequel une quantité de diminution $\Delta N_D$ de la concentration de porteurs est donnée par
   $$\Delta N_D = b \cdot R^c$$
   où b et c sont des constantes.

3. Dispositif à semi-conducteur conformément à la revendication 2, dans lequel les constantes b et c sont
   $$1,99 \times 10^{10} \leqq b \leqq 3,98 \times 10^{10}$$
   $$0,5 \leqq c \leqq 0,8.$$

Fig. I

Fig.2

Fig.3

Fig.4

Fig. 5

Fig.6

Fig.7

Fig.8

Fig.9

Fig.10

Fig.11

Fig. 12